# EUROPEAN PATENT APPLICATION

(11) **EP 4 485 510 A1**
(43) Date of publication of application: **01.01.2025**
(21) Application number: 23181670.3
(22) Date of filing: 27.06.2023
(51) Int. Cl.: H01L 21/56, H01L 23/31, H01L 23/495

(54) **A METHOD OF MANUFACTURING SEMICONDUCTOR ASSEMBLIES**

(71) Applicant: Nexperia B.V., 6534 AB Nijmegen (NL)
(72) Inventor: Yandoc, Ricardo, Manchester, SK7 5BJ (GB); Brown, Adam, Manchester, SK7 5BJ (GB)
(74) Representative: Pjanovic, Ilija

(57) **Abstract**

There is disclosed a method of manufacturing a batch of semiconductor assemblies. The method comprises coupling a plurality of dies to a plurality of die paddles, the plurality of die paddles being provided on a lead frame in a 2 x n array in pairs having an opposing orientation. Each die paddle defines a respective semiconductor assembly. The method further comprises coupling a plurality of connectors to the plurality of dies. The method further comprises moulding a fused casing over the plurality of semiconductor assemblies using a mould which surrounds the 2 x n array, the fused casing at least partly surrounding the 2 x n array. The method further comprises cutting the fused casing at at least three positions, partially surrounding an individual one of the plurality of semiconductor assemblies, and punching a lead side of the semiconductor assembly, to define an individual casing, from the fused casing, and singulate the semiconductor assembly from the 2 x n array.

## Description

The present invention relates to a method of manufacturing a batch of semiconductor assemblies, a semiconductor assembly, and an array of semiconductor assemblies.

Semiconductor assemblies, such as transistors, are manufactured as layered assemblies including components such as die paddles, dies, connectors and a casing. The casing provides a protective functionality and at least partially surrounds the die and other components forming part of the semiconductor assembly. The casing may otherwise be referred to as an encapsulant.

It is desirable to produce semiconductor assemblies, such as transistors, having as low a component resistance as possible, to reduce losses in operation associated with the generation of heat. One way to reduce the component resistance is to increase a size of the die, an electrical component which is coupled to the die paddle. That is to say, a larger die can provide a semiconductor assembly having a lower component resistance. However, the size of the die is limited by the area available on the die paddle, which the die is coupled to. It is also desirable to maintain a particular footprint of semiconductor assembly (i.e. to not increase the overall size of the semiconductor assembly) to provide supply chain continuity and maintain compatibility. It is also desirable to improve the efficiency of manufacture of semiconductor assemblies.

There exists a need to overcome the disadvantages associated with existing semiconductor assemblies, and associated methods of manufacture, whether mentioned in this document or otherwise.

According to a first aspect of the invention there is provided a method of manufacturing a batch of semiconductor assemblies, comprising:
coupling a plurality of dies to a plurality of die paddles, the plurality of die paddles being provided on a lead frame in a 2 x n array in pairs having an opposing orientation, wherein each die paddle defines a respective semiconductor assembly;
coupling a plurality of connectors to the plurality of dies;
moulding a fused casing over the plurality of semiconductor assemblies using a mould which surrounds the 2 x n array, the fused casing at least partly surrounding the 2 x n array; and
cutting the fused casing at at least three positions, partially surrounding an individual one of the plurality of semiconductor assemblies, and punching a lead side of the semiconductor assembly, to define an individual casing, from the fused casing, and singulate the semiconductor assembly from the 2 x n array.

A batch of semiconductor assemblies may be referred to as a plurality of semiconductor assemblies.

The lead frame and/or die paddle(s) may otherwise be described as a plate of conductive material. The die paddle may be manufactured from a copper alloy or entirely from copper.

The die paddles being provided on a lead frame in a 2 x n array in pairs having an opposing orientation may otherwise be described as the array being defined by a number of pairs of die paddles arranged in a back-to-back manner. For example, the lead sides of the die paddles, for a given pair, face opposing directions. Described another way, second sides (e.g. opposite the lead side) of the die paddles (which form an opposed pair) are proximate one another.

Each die paddle defining a respective semiconductor assembly may otherwise be described as each individual die paddle going on to form a separate semiconductor assembly.

The die may be a single component or may comprise multiple constituent components. The die is preferably coupled to the die paddle using solder. The die being coupled to the die paddle may otherwise be described as the die being attached to the die paddle. The die may be a silicon chip. The plurality of dies may be coupled to a respective plurality of die paddles (e.g. one die per die paddle).

The connector may comprise a clip. The connector may be wirebonded to the die, or coupled using any other internal connection (e.g. a ribbon band). The clip may comprise one or more legs. The clip may be described as a conductive body by which the semiconductor assembly is connected, or connectable, to an external electrical circuit in use. The clip may be coupled to the die paddle by virtue of being coupled to the die. Described another way, the clip maybe described as being indirectly coupled to the die paddle. The clip is preferably coupled to the die by solder. The plurality of connectors may be coupled to a respective plurality of dies (e.g. one connector per die paddle).

Fused casing is intended to refer to a conjoined casing moulded in a single mould. For example, the fused casing may be moulded over multiple pairs of die paddles as defined by the 2 x n array. Cutting the fused casing may comprise using a reciprocating or rotating blade (e.g. sawing), laser or waterjet cutting process. Cutting the fused casing at at least three positions may otherwise be described as making three cuts (e.g. along three lengths) through the fused casing. Cutting the fused casing at at least three positions may otherwise be described as the fused casing being cut along at least three lengths. For a quadrangular semiconductor assembly, the at least three positions of the fused casing which are cut preferably correspond to three sides of that quadrangle. The at least three positions are preferably linked to one another insofar as a beginning of one position corresponds to the end of an adjacent position. For a quadrangle, the at least three positions may be the sides of a U-shape (e.g. three out of four sides of a quadrangular perimeter). Cutting is intended to refer to an operation in which material is gradually removed along a profile (e.g. by sawing, laser cutting or a waterjet cutting process). The cutting operation may be carried out on the fused casing and the die paddle (e.g. tie bars). Cutting encompasses an operation in which there is relative transverse movement between the cutting edge and the array (e.g. as opposed to a purely axial movement, such as for punching). For example, the array may be moved relative to the cutting edge (e.g. with respect to a rotary saw). Alternatively, the cutting implement may be moved relative to the array (e.g. in the case of laser cutting or water jetting).

Cutting the fused casing at at least three positions, partially surrounding an individual one of the plurality of semiconductor assemblies, may comprise the casing (of an individual semiconductor assembly) being cut on any, and all, adjoining sides.

The casing may otherwise be described as a capsule or shield. The casing maybe described as encapsulating the die. The casing advantageously reduces the risk of contaminants, such as moisture, penetrating into the semiconductor assembly. The casing preferably extends between both first and second major faces of the die paddle. The casing may be plastic. The casing may otherwise be described as being manufactured from a polymer. The casing is preferably manufactured using an injection moulding process where an at least partially molten material is moulded into the desired casing shape. The plastic may be a thermoplastic (e.g. a thermosetting polymer).

Punching the lead side of the semiconductor assembly may be described as punching a connector (e.g. a clip) at the lead side. Punching the lead side of the semiconductor assembly may be described as punching the free, exposed edge, of the fused casing (i.e. an edge or side of the fused casing which is not adjacent to another semiconductor assembly and which is not attached to the lead frame, at that side, by one or more tie bars). Punching is intended to refer to an operation in which a single action (e.g. downward stroke of a punch) shears material to remove material. The punching operation may be carried out on the connector only (e.g. not on the fused casing). Punching encompasses an operation in which there is only relative axial movement between the cutting edge and the array (e.g. as opposed to transverse movement, such as for cutting). Punching encompasses an operation in which the array is fixed in position, and only the punch moves.

Singulating the semiconductor assembly from the 2 x n array may otherwise be described as separating, or detaching, the semiconductor assembly from the 2 x n array. Alternatively, it may be described as severing the semiconductor assembly from the 2 x n array.

Advantageously, the invention means that a second punching operation, at a non-lead side of the semiconductor assembly, can be omitted, in favour of a cutting step. This, in turn, means that the size of die accommodated by the die paddle can be advantageously increased (providing a component resistance advantageously reduced by up to around 20%). Furthermore, the density of die paddles on a lead frame can be increased, providing a desirable reduction of (costly) wasted lead frame/die paddle material (e.g. copper), with a corresponding improvement in cost efficiency. The invention also advantageously allows a thicker casing to be moulded, which improves reliability and reduces warping during manufacture. The risk of damage occurring to the casing during a punching operation is also reduced by virtue of the fused casing being sawed at at least three positions.

Moulding the fused casing may comprise defining a groove which extends at least partway around one of the plurality of semiconductor assemblies.

The groove may otherwise be described as a recess or cavity. The groove may be described as an absence of material. The groove may be linear (e.g. extending in a straight line) or may be at least partly arcuate. The groove extending at least partway around one of the plurality of semiconductor assemblies may be described as the groove at least partially defining an outer perimeter of one of the plurality of semiconductor assemblies (after singulation).

Advantageously, incorporation of the groove reduces the amount of material which needs to be removed by the cutting process. As such, tool wear is reduced, and cutting can occur more swiftly. Furthermore, by defining the groove as part of the moulding process, rather than the material being introduced in the mould and then subsequently removed, the material is never present. Material wastage is thus reduced.

The groove may extend continuously around the three positions of the fused casing partially surrounding the individual one of the plurality of semiconductor assemblies.

The groove extending continuously around the three positions of the fused casing may be described as the groove extending continuously around three lengths defined in the fused casing. The groove extending continuously may mean that a single groove is defined, but that single groove comprises a plurality of portions. The combination, or sum, of the portions may define the overall groove. For example, the groove extending continuously around three positions may mean that the groove is substantially U-shaped (e.g. three linear portions, each one being joined to at least one other, with 90 degrees between each of the main).

Advantageously, the groove extending continuously around the three positions of the fused casing, and partially surrounding the individual one of the plurality of semiconductor assemblies, means that a majority of a perimeter of the individual semiconductor assembly is defined by a groove. The cutting process is therefore more efficient, because less material has to be removed in order to singulate the semiconductor assembly.

The groove may extend intermittently around the three positions of the fused casing partially surrounding the individual one of the plurality of semiconductor assemblies.

The groove extending intermittently is intended to mean that the groove is not a continuous groove. For example, the groove may be considered to be defined by a plurality of portions, but the portions are not adjoined to one another. That is to say, there may be a `full' thickness of (fused) casing between two adjacent portions.

The groove may be at least partially tapered.

The groove being at least partially tapered is intended to mean that the groove has an inclined side (e.g. a chamfered edge).

Advantageously, the groove being at least partially tapered facilitates the moulding process and avoids the introduction of stress raisers which may result from sharp corners.

The groove may comprise a flat surface proximate a respective die paddle.

The groove comprising a flat surface proximate a respective die paddle may be described as a lower surface of the groove having a flat bottom. Described another way, when viewed in cross section the groove may have a linear lower surface.

Advantageously, the incorporation of a flat bottom groove provides ease of singulation and reduces an alignment tolerance of the cutting method.

The groove may extend through at least 1/3 of a thickness of the individual casing.

The groove extending through at least 1/3 of a thickness of the individual casing may otherwise be described as defining a minimum depth of the groove. The thickness of the individual casing may also correspond to a thickness of the fused casing, given that the cutting operation may not alter a thickness of the casing (only separate a fused casing into a plurality of the same thickness single casings). Put another way, the groove may extend through at least 1/3 of a thickness of the fused casing.

The groove extending through at least 1/3 of a thickness of the casing has advantageously been found to improve the efficiency of the cutting process, and aid singulation of the semiconductor assembly.

Punching the lead side of the semiconductor assembly to define the individual casing may occur before cutting the fused casing at at least three positions.

Advantageously, punching the lead side of the semiconductor assembly may comprise forming one or more leads of the connector. Punching the lead side of the semiconductor assembly to define the individual casing before cutting the fused casing advantageously means that the leads are exposed, whilst the fused casing remains intact. Further processes, such as plating, can therefore occur on the leads whilst the arrays of die paddles and semiconductor assemblies remain coupled to the lead frame (and are therefore constrained in their position, aiding in the manufacturing tolerance).

Cutting the fused casing at at least three positions may singulate the semiconductor assembly from the 2 x n array.

The cutting at at least three positions may occur simultaneously. Semiconductor assemblies from one array, or all arrays, can be singulated, by cutting, simultaneously.

Advantageously, singulating the semiconductor assembly via the cutting step has been found to avoid formation of cracks in the corners of the die, and reduce delamination, compared to singulating by a punching step. Further advantageously, by singulating at the cutting step, the arrays are still defined before the cutting step. It has been found to be easier to align an array, for the cutting operation, with respect to the cutting implement.

The lead frame may comprise a plurality of 2 x n arrays of die paddles, pairs of the die paddles of each 2 x n array being provided in an opposing orientation; and
moulding the fused casing may comprise moulding a plurality of fused casings, one for each of the plurality of 2 x n arrays of die paddles.

The lead frame may comprise two or more 2 x n arrays of die paddles.

One casing for each of the plurality of 2 x n arrays of die paddles may otherwise be described as there being a respective fused casing for each 2 x n array of die paddles.

Advantageously, by providing a plurality of 2 x n arrays on a single lead frame, manufacture of the semiconductor assemblies can be made more efficient. For example, wastage can be reduced and the other processes can be carried out on a greater number of semiconductor assemblies, simultaneously, owing to there being a plurality of 2 x n arrays.

The plurality of fused casings may be moulded simultaneously by supplying molten material, from a common source, through a respective runner for each fused casing.

Advantageously, the plurality of fused casings being moulded simultaneously can improve the efficiency of the manufacture of the fused casings. For example, a single source of molten material can be used by any number of 2 x n arrays of die paddles.

Punching the lead side of the semiconductor assembly may comprise forming one or more displaced leads.

Displaced leads is intended to refer to a lead (e.g. a leg) of the connector which incorporates at least one change of direction after extending through the casing. For example, the displaced lead may have a generally S-shaped, J-shaped, U-shaped or other geometry (e.g. when viewed in cross section).

Displaced leads have advantageously been found to provide improved board level reliability by acting as a stress reliever when the semiconductor assembly is installed in an electrical circuit. Forming the displaced leads in the punching step eliminates the need to punch the lead side and then separately form a displaced lead at a later step of the process.

According to a second aspect of the invention there is provided a semiconductor assembly manufactured using the method according to the first aspect of the invention.

According to a third aspect of the invention there is provided an array of semiconductor assemblies, comprising:
a lead frame comprising a 2 x n array of die paddles, the die paddles being arranged in pairs having an opposing orientation, wherein each die paddle defines a respective semiconductor assembly;
a plurality of dies coupled to a respective plurality of die paddles;
a plurality of connectors coupled to the respective plurality of dies;
a fused casing moulded over the plurality of semiconductor assemblies, the fused casing at least partly surrounding the 2 x n array; wherein
each of the plurality of semiconductor assemblies comprises one or more leads extending from a lead side of the semiconductor assembly.

The die paddle(s) may otherwise be described as a plate of conductive material. The die paddle(s) may be manufactured from copper.

The die maybe a single component or may comprise multiple constituent components. The die is preferably coupled to the die paddle using solder. The die being coupled to the die paddle may otherwise be described as the die being attached to the die paddle. The die may be a silicon chip.

The connector may comprise a clip. The connector may be wirebonded to the die. The clip may comprise one or more legs. The clip may be described as a conductive body by which the semiconductor assembly is connected, or connectable, to an external electrical circuit in use. The clip may be coupled to the die paddle by virtue of being coupled to the die. Described another way, the clip maybe described as being indirectly coupled to the die paddle. The clip is preferably coupled to the die by solder. The leads may be integral with a dambar (i.e the dambar may not have yet been removed, where a dambar is present). The 'leads' may therefore otherwise be described as a projecting portion of the connector (e.g. projecting beyond the casing).

The casing may otherwise be described as a capsule or shield. The casing maybe described as encapsulating the die. The casing advantageously reduces the risk of contaminants, such as moisture, penetrating into the semiconductor assembly. The casing preferably extends between both first and second major faces of the die paddle. The casing may be plastic. The casing may otherwise be described as being manufactured from a polymer. The casing is preferably manufactured using an injection moulding process where an at least partially molten material is moulded into the desired casing shape. The plastic may be a thermoplastic (e.g. a thermosetting polymer).

Advantageously, an array of semiconductor assemblies as described above improves the efficiency of the manufacture process by moulding the fused casing over a plurality of semiconductor assemblies. The density of die paddles on the lead frame, and the number of semiconductor assemblies that can be manufactured as a result, is therefore increased.

Each of the plurality of semiconductor assemblies may comprise one or more displaced leads extending from the lead side of the semiconductor assembly. Each of the plurality of semiconductor assemblies may comprise one or more (optionally, displaced) leads extending from a single lead side of the semiconductor assembly. That is to say, for each semiconductor assembly, leads may only extend from one (lead) side. For the 2 x n array, leads of the connectors may only extend from one of two sides of the 2 x n array. That is to say, for a first row of the 2 x n array, leads extend from only the lead side of those semiconductor assemblies. For a second (i.e. the other) row of the 2 x n array, leads extend from only the lead side of those (different) semiconductor assemblies.

Displaced leads is intended to refer to a lead (e.g. a leg) of the connector which incorporates at least one change of direction after extending through the casing. For example, the displaced lead may have a generally S-shaped, J-shaped, U-shaped or other geometry (e.g. when viewed in cross section).

According to a fourth aspect of the invention there is provided a method of manufacturing a batch of semiconductor assemblies, comprising:
coupling a plurality of dies to a plurality of die paddles, the plurality of die paddles being provided on a lead frame in an array, wherein each die paddle defines a respective semiconductor assembly;
coupling a plurality of connectors to the plurality of dies;
moulding a fused casing over the plurality of semiconductor assemblies using a mould which surrounds the array, the fused casing at least partly surrounding the array; and
cutting the fused casing at at least two positions, partially surrounding an individual one of the plurality of semiconductor assemblies, and punching a single, lead side of the semiconductor assembly, to define an individual casing, from the fused casing, and singulate the semiconductor assembly from the array.

The array may be a 1 x n array, or a 2 x n array. Punching a single, lead side of the semiconductor assembly may otherwise be described as punching only one side of the semiconductor assembly. The combination of the cutting at at least two positions, and punching the single lead side, singulates the semiconductor assembly.

The plurality of dies may be coupled to a respective plurality of die paddles. The plurality of connectors may be coupled to a respective plurality of dies.

According to a fifth aspect of the invention there is provide a semiconductor assembly, comprising:
a die paddle;
a die coupled to the die paddle;
a connector coupled to the die, the connector comprising one or more leads that extend from a single lead side of the die paddle; and
a casing which extends to three sides of the die paddle;
wherein the one or more leads are displaced leads.

The die paddle may otherwise be described as a plate of conductive material. The die paddle may be manufactured from copper, such as an alloy thereof.

The die maybe a single component or may comprise multiple constituent components. The die is preferably coupled to the die paddle using solder. The die being coupled to the die paddle may otherwise be described as the die being attached to the die paddle. The die may be a silicon chip.

The connector may comprise a clip. The connector may be wirebonded to the die. The clip may comprise one or more legs. The clip may be described as a conductive body by which the semiconductor assembly is connected, or connectable, to an external electrical circuit in use. The clip may be coupled to the die paddle by virtue of being coupled to the die. Described another way, the clip maybe described as being indirectly coupled to the die paddle. The clip is preferably coupled to the die by solder. The connector may comprise a plurality of constituent connectors (e.g. a source connector and a gate connector).

The casing may otherwise be described as a capsule or shield. The casing maybe described as encapsulating the die. The casing advantageously reduces the risk of contaminants, such as moisture, penetrating into the semiconductor assembly. The casing preferably extends between both first and second major faces of the die paddle.

The casing may be plastic. The casing may otherwise be described as being manufactured from a polymer. The casing is preferably manufactured using an injection moulding process where an at least partially molten material is moulded into the desired casing shape. The plastic may be a thermoplastic (e.g. a thermosetting polymer). The casing extending to three sides of the die paddle may otherwise be described as the casing extending to three edges of the die paddle. The three sides are preferably each of the non-lead sides of the die paddle.

One or more leads extending from a single lead side of the die paddle is intended to mean that across the entire semiconductor assembly leads only extend from one side. Described another way, all of the other sides are free of leads, save for the single, lead side.

Displaced leads is intended to refer to a lead (e.g. a leg) of the connector which incorporates at least one change of direction after extending through the casing. For example, the displaced lead may have a generally S-shaped, J-shaped, U-shaped or other geometry (e.g. when viewed in cross section).

The optional and/or preferred features of each aspect of the invention as set out herein are also applicable to any other aspects of the invention where appropriate.

Embodiments of the present invention will now be described, by way of example only, with reference to the accompanying drawings in which:
Figure 1 is a perspective view of a semiconductor assembly according to an embodiment of the invention;
Figure 2 is a partially transparent view of the semiconductor assembly of Figure 1;
Figure 3 is a partially transparent view of the semiconductor assembly of Figures 1 and 2 taken from a top (non-lead) side;
Figure 4 is a partially transparent plan view of the semiconductor assembly of Figures 1 to 3;
Figure 5 is a partially transparent view of the semiconductor assembly of Figures 1 to 4 taken from a lead (or bottom) side;
Figure 6 is a side view of the semiconductor assembly of Figures 1 to 5;
Figure 7 is a partially transparent side view of the semiconductor assembly which corresponds to the view shown in Figure 6,
Figure 8 is a partially transparent underside view of the semiconductor assembly of Figures 1 to 7;
Figures 9a to 9i schematically illustrate a method of manufacturing the semiconductor assembly of Figures 1 to 8;
Figure 10 is a magnified view of Figure 9a, showing a lead frame comprising two 5 x 2 arrays of die paddles for use in the manufacture of the semiconductor assembly of the preceding Figures;
Figure 11 is a magnified view of Figure 9f, also showing corresponding side and end views;
Figure 12 is a perspective view of the arrays of semiconductor assemblies, shown in Figure 11, after removal of the mould runners;
Figure 13 is a perspective view of the arrays of semiconductor assemblies, shown in Figure 9g, after a punching operation is carried out;
Figure 14 generally corresponds to the step shown in Figure 9f, further showing a mould section design and end views of arrays of semiconductor assemblies during the moulding step;
Figure 15 is a side view which corresponds to Figure 14;
Figure 16 is a magnified view of part of Figure 14;
Figure 17 corresponds to Figure 16 with the mould section removed;
Figures 18 and 19 show a semiconductor assembly according to another embodiment (in a partially transparent plan, and partially transparent underside, view respectively);
Figures 20 and 21 show a semiconductor assembly according to another embodiment (in a partially transparent plan, and partially transparent underside, view respectively); and
Figures 22a to 22i schematically illustrated a method of manufacturing a batch of semiconductor assemblies according to another embodiment.

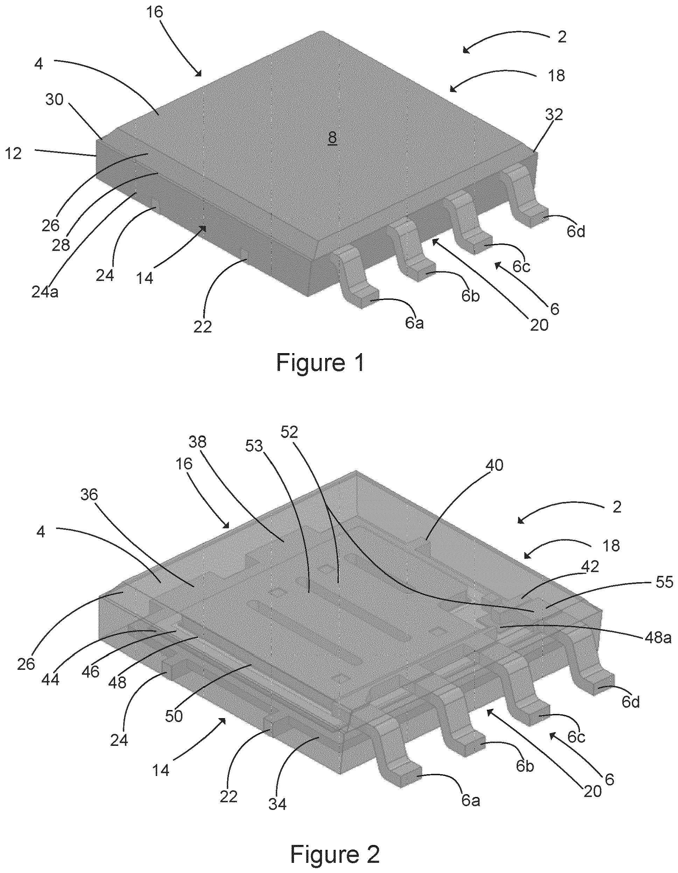

Turning to Figure 1, a perspective view of a semiconductor assembly 2 according to an embodiment is provided. The semiconductor assembly 2 may otherwise be referred to as a semiconductor component, or a component. As shown in Figure 1, the semiconductor assembly 2 comprises a casing 4 and leads 6a-d (collectively referred to as leads 6). The casing 4 surrounds at least part of the semiconductor assembly 2, and provides a protective functionality. The casing 4 may be otherwise referred to as an encapsulant. The casing 4 is typically a plastic material, such as a thermosetting polymer.

The leads 6 may otherwise be referred to as legs. It is by the leads 6 that the semiconductor assembly 2 is connected to an electrical circuit in operation. The leads 6 are thus conductive. The leads 6 are preferably manufactured from copper, such as a copper alloy.

Figure 1 is taken from a generally first major face 8 (e.g. upper side) perspective. Although not shown in Figure 1, a second major face (e.g. underside) opposes the first major face 8.

The major faces are at least partly defined by an outer perimeter 12, the outer perimeter 12 being defined by four sides in the illustrated embodiment. The sides may be referred to as a first side 14, a second side 16, a third side 18 and a lead, or fourth, side 20. Lead side refers to a side of a die paddle, casing or semiconductor from which the leads 6 extend. In the illustrated embodiment the first, second and third sides 14, 16, 18 and lead side 20 entirely define the outer perimeter 12 of the casing 4. In other embodiments there may be more, or fewer, sides, and a different geometry may thus be defined. That said, in the illustrated embodiment the outer perimeter 12 is quadrangular (e.g. rectangular).

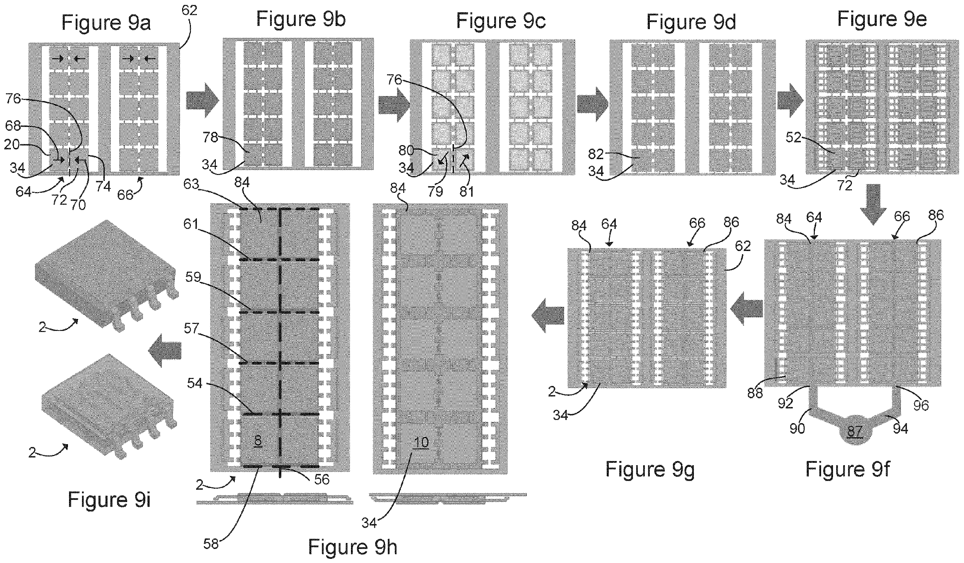

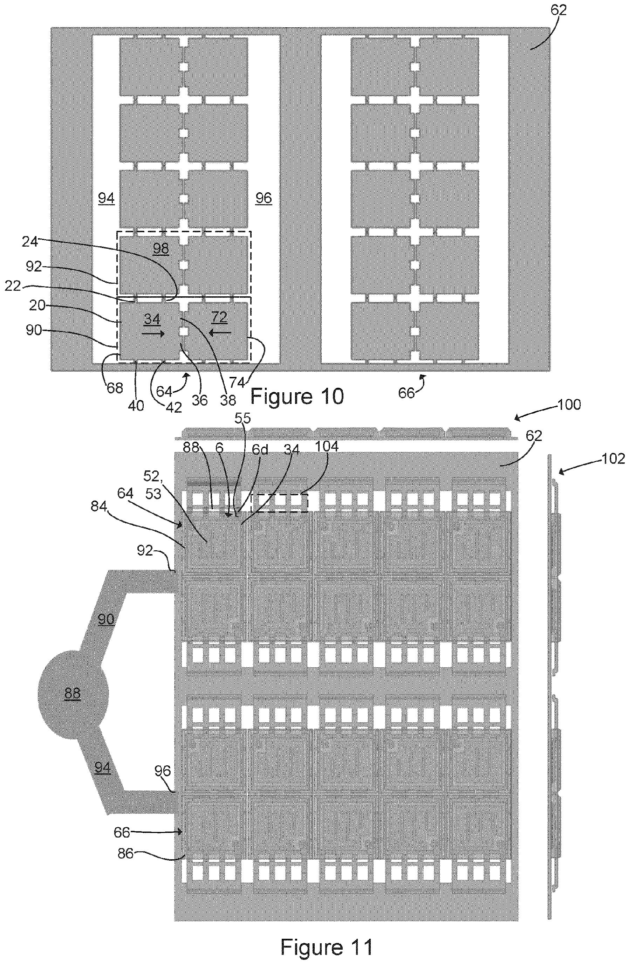

Although only visible on the first side 14 in Figure 1, each of the first to third sides 14, 16, 18 has one or more tie bars, of a die paddle, projecting therethrough. As will be described in detail in connection with later Figures, for example Figures 9a and 10, the tie bars couple the die paddle (i.e. a conductive plate of material, to which other components of the semiconductor assembly are attached) to a lead frame (which comprises a plurality of die paddles). In order to singulate the semiconductor assembly 2 from an array (i.e. separate an individual semiconductor assembly) the tie bars, and casing, are cut. Tie bars are labelled 22, 24 in Figure 1. Further tie bars project from the second and third side 16, 18 and are partially visible in Figure 2. The tie bars are integral with the die paddle, and are therefore manufactured from whichever material the die paddle is manufactured (e.g. copper, such as a copper alloy).

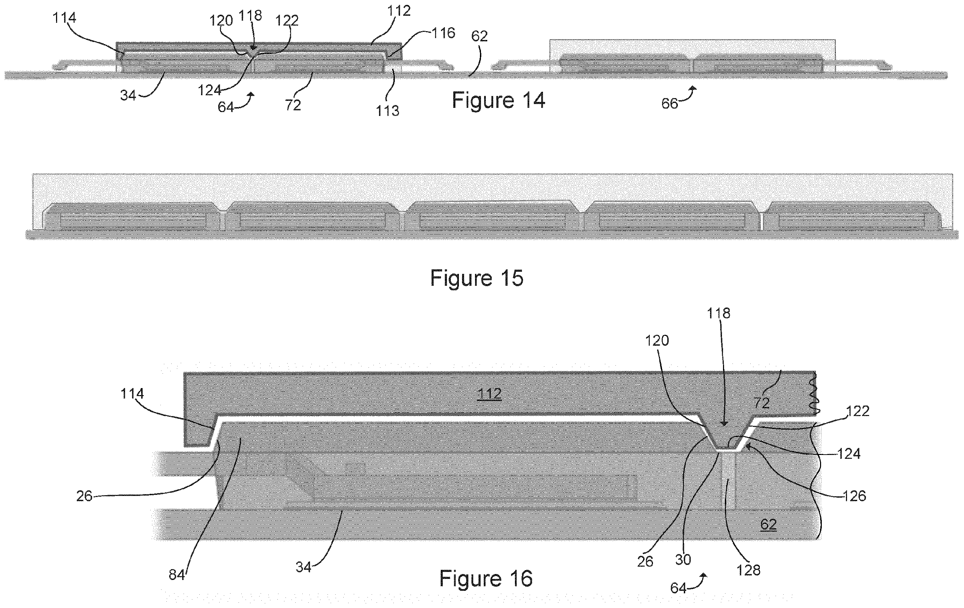

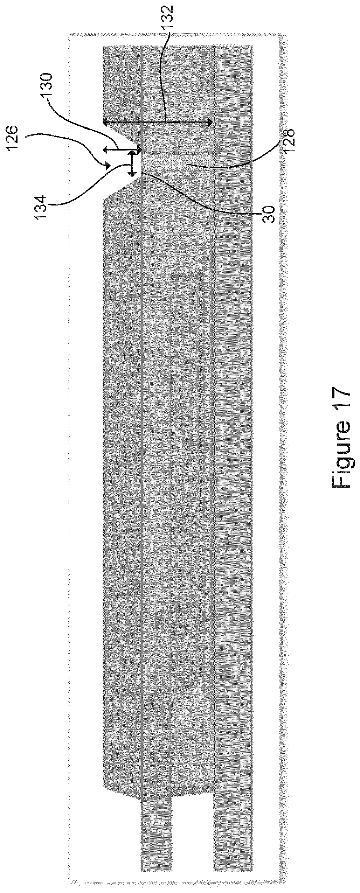

The casing 4 further comprises chamfered edge 26. In the illustrated embodiment the chamfered edge 26 extends entirely around the casing 4 (e.g. around a perimeter thereof). That is to say, each of the first to fourth sides 14, 16, 18, 20 comprises a respective chamfered edge, which join with each other to define a closed loop. However, in other embodiments this may not be the case. For example, the chamfer may only extend around some of the sides, or may be intermittent in nature (e.g. as opposed to continuous in the illustrated embodiment). In some embodiments the chamfered edge 26 may be omitted entirely (i.e. the casing 4 may not comprise any such chamfer). Also of note, the first side 14 comprises a lip 28 at least partially defined by the chamfered edge 26. The chamfered edge 26 therefore does not meet a first face 24a of the first side 14 at an apex (e.g. in a flush manner). Instead, the alignment of the chamfer 26, with respect to the first face 24a, defines the lip 28. As will be described in connection with later figures, such as Figures 16 and 17, the lip 28 is formed when a cutting operation is carried out to separate the (individual) semiconductor assembly 2 from the array (e.g. comprising a plurality of semiconductor assemblies). The lip 28 may therefore be described as attributable to a manufacturing tolerance which remains after the cutting operation has been carried out. For completeness, and only partially visible in Figure 1, each of the second and third sides 16, 18 each comprise a respective lip 30, 32. The lips 28, 30 and 32 may be described as first, second and third portions of an overall lip which extends around three sides 14, 16, 18 of the casing 4. Of note, there is no such lip on the lead side 20 (owing to that side of the semiconductor assembly 2 not being `cut', but punched instead). As will be appreciated from Figure 1, the leads 6 only extend from a single (lead) side 20 of the semiconductor assembly. Each of the first to third sides 14, 16, 18 are free of any leads. Put another way, a corresponding connector, of which the leads 6 form part, does not project through any of the first to third sides 14, 16, 18 (e.g. any non-lead sides). The combination of the chamfered edge 26 and lip 30 advantageously eases removal of a package (e.g. semiconductor assembly with a moulded casing) from the mould cavity, as will be appreciated from Figures 14 to 17. For completeness, in contrast to tie bars 22, 24, which are integral with the die paddle and couple the die paddle to a surrounding lead frame during manufacture (e.g. see Figure 9a), leads 6 are part of a connector and project outwardly beyond the casing 4.

Figure 1 also shows that each of the leads 6 is a displaced lead. Displaced lead is intended to mean that the lead changes direction along its extent. Gullwing leads, such as that shown in Figure 1, are one example of a displaced lead, although other geometries are otherwise possible (e.g. J-leads, to name another example). Any lead which undergoes a change of direction (e.g. incorporates a bend, fillet or chamfer along its extent) is considered a displaced lead.

As will be described in connection with the later Figures, the inventors have identified an improved manufacturing process for manufacturing the semiconductor assembly 2 wherein the lead side 20 of the semiconductor assembly 2 (only) is punched (to define the leads 6) and the three sides 14, 16, 18 of the casing 4 are cut, to separate a fused casing (e.g. a casing which comprises one or more individual casings in a conjoined manner) to singulate, or separate, the semiconductor assembly 2 from an array. This will be described in more detail in connection with Figures 9a-i, showing a method of manufacture.

Turning to Figure 2, a partially transparent view of the semiconductor assembly 2 shown in Figure 1 is provided. The partially transparent view refers to the opacity of the casing 4 (partially transparent in Figure 2), which allows otherwise-obscured internal components of the semiconductor assembly 2 to be seen.

Beginning first with a die paddle 34, the die paddle 34 forms an effective base of the semiconductor assembly 2, to which other components are attached. The die paddle 34 is a plate-like component. The die paddle 34 is generally quadrangular, and is manufactured from a conductive material such as copper (e.g. including copper alloy). As previously mentioned, tie bars 22, 24 (on the first side 14) of the die paddle 34 are how the die paddle 34 is secured in a lead frame, which comprises an array of die paddles, during manufacture. Also visible in Figure 2 are tie bars 36, 38, which project through the second side 16, and tie bars 40, 42 which project through the third side 18. Each of the non-lead sides (e.g. first to third sides 14, 16, 18) thus comprise a plurality of tie bars (e.g. two tie bars) in the illustrated embodiment. However, in other embodiments each of the non-lead sides (e.g. first to third sides 14, 16, 18) may comprise one (e.g. a single) tie bar. It is therefore preferably that each of the non-lead sides (e.g. first to third sides 14, 16, 18) comprises one or more tie bars.

Coupled to the die paddle 34 is a layer of solder 44 (just visible in Figure 2). The solder layer 44 is used to secure a die 46, 48 to the die paddle 34. Numerals 46, 48 collectively denote the die. A layer 46, typically silicon nitride, is a non-solderable surface of the die. Adjacent layer 48 is a solderable surface (e.g. TiNi(V)Ag) of the die. For completeness, 48a is a a solderable surface of a gate portion of the die, and is collectively referred to by numeral 48. The solderably surface of the die therefore has two constituent parts. Just visible in Figure 2 is another layer of solder 50 which is applied to the die 48. The solder 50 is used to couple a connector 52 to the die 48.

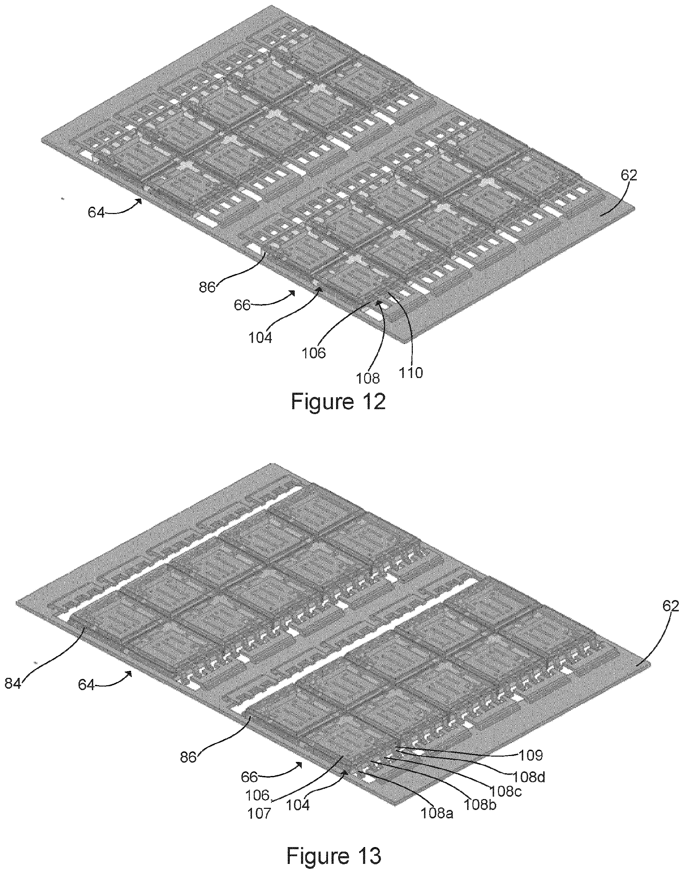

The connector 52 may be referred to as a clip. In the illustrated embodiment the connector 52 comprises a source connector 53 and a gate connector 55 (which may be referred to as constituent connectors). The connector 52 is therefore a multipart connector. The source connector 53 and gate connector 55 are initially part of a single-piece connector which, after a corresponding dambar is trimmed, are separated (observed by comparing Figures 12 and 13, for example). The source connector 53 may be referred to as a source clip. The gate connector 55 may be referred to as a gate clip. The leads 6 form part of the connector 52. Specifically, leads 6a-c form part of the source connector 53 (and may therefore be referred to as source leads), and lead 6d forms part of the gate connector 55 (and may therefore be referred to as a gate lead). In other embodiments, the connector may comprise more, or fewer, constituent connectors. For example, where the semiconductor assembly is a diode, the assembly may comprise a single clip (e.g. a single, single-piece connector). The connector may also comprise three or more constituent connectors, particularly where the device has more than two terminals on an upper surface. The number of leads, in other embodiments, may be as low as one. That is to say, there is at least one lead. The four leads 6a-d in the illustrated example are just one non-limiting example.

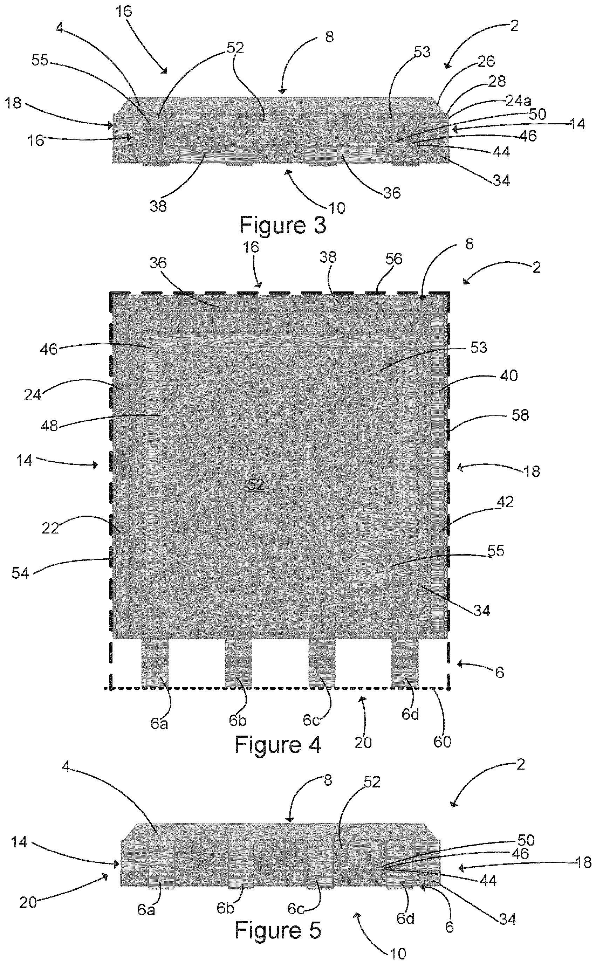

Turning to Figure 3, an end view of the semiconductor assembly 2 is provided as viewed from the second side 16. As such, tie bars 36, 38 are visible in that they project from the second side 16. Figure 3 also shows the layered nature of the assembly of the die paddle 34, the solder layer 44, die 46, solder layer 50, and the connector 52 (with source and gate connectors 53, 55). For completeness, Figure 3 also shows the first major face 8 as being an upper face, and the second major face 10 as being a lower face. The end view of Figure 3 also shows more clearly the chamfer 26 and first portion of the lip 28. Figure 3 indicates that the first portion of the lip 28 can be considered to form a step between the major face 24a (of the first side 14) and the chamfer 26. A corresponding arrangement is provided on the opposing side (i.e. the third side 18).

Turning to Figure 4, a partially transparent view of the semiconductor assembly 2 is provided taken from the perspective of the first major face 4. Figure 4 may otherwise be described as a partially transparent plan view of the semiconductor assembly 2. Also schematically indicated in Figure 4 are first to third cut lines 54, 56, 58 and a punch line 60. As suggested, the first to third cut lines 54, 56, 58 indicate three positions (i.e. lengths) where a fused casing (e.g. see fused casing 84 of Figure 9h) is cut to singulate the semiconductor assembly 2 (i.e. to separate the individual semiconductor assembly 2 from an array). Similarly, the punch line 60 schematically indicates a position, at the lead side 20 of the semiconductor assembly 2, which is punched to separate the lead side 20 from a surrounding lead frame (and optionally singulate the semiconductor assembly 2 from the array). Of note, it will be appreciated that, depending on the order of the cutting and punching process being carried out, either one, or both, of the processes may actually separate (e.g. singulate) the semiconductor assembly 2. Put another way, if the punching process occurs first, then it will be by the fused casing (and tie bars) that the semiconductor assembly 2 is still coupled to the surrounding array/lead frame (and thus the cutting operation(s) will singulate the semiconductor assembly 2). In preferred embodiments the punching operation occurs first, and the cutting occurs after the punching.

As used throughout this document, cutting is intended to refer to an operation in which material is gradually removed along a profile (e.g. by sawing, laser cutting or a waterjet cutting process). Cutting encompasses an operation in which there is relative transverse movement between the cutting edge and an array (to be cut) (e.g. as opposed to a purely axial movement, such as for punching). For example, the array may be moved relative to the cutting edge (e.g. with respect to a rotary saw). Alternatively, the cutting implement may be moved relative to the array (e.g. in the case of laser cutting or water jetting). The cutting operation can be used to cut ductile materials (e.g. metal) and brittle materials (e.g. plastic). The cutting operation can be therefore be used to cut metal, plastic, or a hybrid (e.g. composite) of the two. Array refers to a collation of not-yet-singulated semiconductor assemblies (e.g. see Figure 9h). In contrast, punching is intended to refer to an operation in which a single action (e.g. downward stroke of a punch) shears material to remove material. Punching encompasses an operation in which there is only relative axial movement between the cutting edge and the array (e.g. as opposed to transverse movement, such as for cutting). Punching encompasses an operation in which the array is fixed in position, and only the punch moves. The punching operation can only be used to cut ductile materials (e.g. metal). The punching operation can therefore be used on metal (e.g. of the die paddle), but not plastic (e.g. not the casing).

The cutting operations primarily cut through the fused casing (e.g. through a polymer) but from Figure 4 it will also be appreciated that tie bars 22, 24, 36, 38, 40, 42 are also cut by way of the cutting process.

Figure 4 indicates that the combination of the three cutting lines 54, 56, 58 (i.e. three positions) and punch line 60 define a closed loop geometry (a quadrangle [e.g. a rectangle] in the illustrated embodiment).

Turning to Figure 5, a partially transparent end view of the semiconductor assembly 2 is provided, taken from the lead end 20 of the semiconductor assembly 2. Figure 5 thus shows each of the leads 6, and also shows the die paddle 34, solder layers 44, 50 die 46 and connector 52.

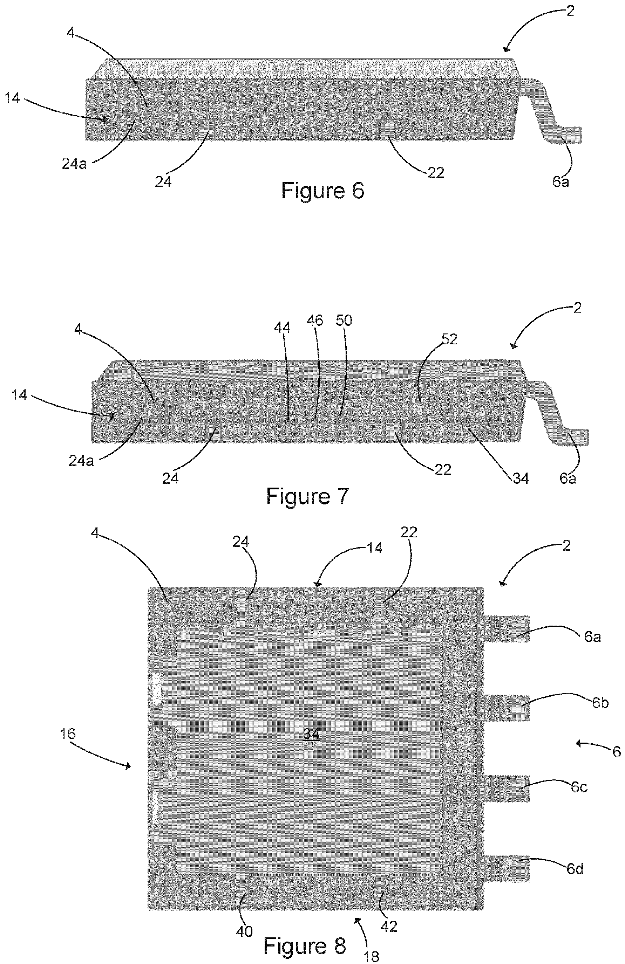

Turning to Figures 6 and 7, side views of the semiconductor assembly 2 are provided in a non-partially transparent view and partially transparent view (Figures 6 and 7 respectively) from the first side 14 perspective. Many of the features shown in Figures 6 and 7 have already been described in detail and will therefore not be repeated here for brevity. However, Figures 6 and 7 do show tie bars 22, 24 extending through the first side 14 (specifically a major face 24a thereof) and a geometry of a lead 6a, which is a displaced lead.

Turning now to Figure 8, Figure 8 is a partially transparent view of the semiconductor assembly 2 from the perspective of the second major face (e.g. underside) of the assembly 2. Figure 8 demonstrates that a significant proportion of the die paddle 34 is visible (e.g. not obscured by the casing 4) at the second major face 10. That said, Figure 8 still shows the casing 4 extends to each of the first, second and third sides 14, 16, 18. Tie bars 22, 24, 40, 42 are also visible and, as previously described, project through the casing 4.

The semiconductor assembly 2 according to the invention is particularly advantageous in that the space available on the die paddle 34, for receipt of the die 48, is increased for a given semiconductor assembly footprint size (e.g. 5 x 6 mm). This is achieved by a change of design of the die paddle, which, in turn, is achievable by virtue of changing the process by which the casing 4 is moulded and the semiconductor assembly is singulated. Whilst it is known to individually mould the casing for each semiconductor assembly (i.e. using a mould cavity for each semiconductor assembly), and then punch each semiconductor assembly on two or more sides to singulate, the inventors have discovered that by moulding the fused (i.e. conjoined) casing over a plurality of semiconductor assemblies, provided in a 2 by n array, cutting the fused casing at at least three positions, and punching a lead side of the semiconductor assembly at one side, more of the die paddle can be made available for receipt of a die, and component resistance of the manufactured semiconductor assembly can therefore be reduced (by virtue of the die size being increased).

Cutting in at least three positions, in contrast to punching on two or more sides, means a distance from the die paddle to a cut line can be reduced. Cutting in at least three positions, in contrast to punching on two or more sides, also means a higher density of die paddles, and so semiconductor assemblies, can be provided on a given leadframe. This is because punching requires `dead' space (i.e. what will be wasted material) to be able to remove the punched material. A cut line is therefore narrower than a punch line, reducing a clearance needed between adjacent die paddles, and so semiconductor assemblies. Where each semiconductor assembly has a corresponding cavity in the mould, and is singulated by way of a punch (i.e. on all sides), a larger area on the leadframe is required for that die paddle (in contrast to the present invention).

Turning to Figures 9a-9i, a method of manufacturing a batch of semiconductor assemblies, corresponding to the semiconductor assembly 2 shown in Figures 1-8, is schematically illustrated. The method may otherwise be described as a process flow.

Beginning at Figure 9a, a lead frame 62 is shown, in plan view. The lead frame 62 is effectively a sheet of material, with material having been selectively removed, such as by stamping or etching, in order to define plurality of die paddles (two of which are labelled 34, 72). The lead frame 62 may otherwise be described as a common lead frame. The lead frame 62 comprises two 2 x 5 arrays 64, 66 of die paddles. As such, each array comprises 10 (conjoined) die paddles. The 2 x 5 arrays of die paddles are on example of a 2 x n array of die paddles. The 2 x n array of die paddles is intended to mean that there may be any number of adjacent (opposed) pairs (e.g. the '2' of the 2 x n) as part of the process. As mentioned above, two die paddles are labelled 34, 72 for ease of understanding. Although in the illustrated embodiment the lead frame 62 comprises two arrays 64, 66, it will be appreciated that in other embodiments more, or fewer, arrays could otherwise be provided. For example, the lead frame could comprise a single array. Alternatively, the lead frame may comprise 3, 4, 5 or more arrays.

Each of the arrays 64, 66 comprises die paddles arranged in pairs and having an opposing orientation. This is intended to mean that there is at least one plane of symmetry between an adjacent pair of die paddles. For example, with reference to Figure 9a, and taking the bottom pair of the array 64 as an example, arrows 68, 70, overlaying the die paddle 34 and the die paddle 72 (which form an opposing pair), each point to a corresponding second, or top, side of the die paddle. Lead sides of each of the die paddles 34, 72 are labelled 20 and 74 respectively. Described in a final different way, a plane of symmetry 76 exists between the two die paddles 34, 72 which form a (opposing) pair. To further illustrate the opposing orientation definition, the upper pairs of die paddles for each of the first and second arrays 64, 66 are also labelled with corresponding arrows pointing towards the second side (i.e. opposing the lead side). As will be described in detail in Figure 10, which is a magnified view of the Figure 9a lead frame 62, the die paddles are also interconnected with one another by tie bars (e.g. the tie bars described and shown in connection with Figure 2) on the lead frame 62.

The opposing orientation of the pairs of die paddles of each of the 2 x 5 arrays 64, 66 is of importance because it means that the single, fused casing can be moulded over a plurality of semiconductor assemblies, simultaneously. The density of die paddles on a lead frame can be increased and, in turn, larger dies can be applied to the die paddles as less space is required between adjacent die paddles due to the manufacturing process. Put another way, a clearance which was previously needed in order to fit the mould around the individual semiconductor assemblies, to mould a single casing, and which reduced the density of die paddles on the lead frame, is no longer required.

Turning to Figure 9b, in a subsequent step of the process a solder layer is printed on each of the die paddles. The solder layer may be applied by a screen printing process. For example, taking the die paddle 34 as an example, a solder layer 78 is printed. The solder layer may be described as being dispensed or applied to the die paddle. The solder layer is preferably applied to all of the die paddles in this single process step. The solder layer is preferably applied to all of the die paddles simultaneously. The solder layer may be applied to the die paddles in a consecutive manner (e.g. die paddle by die paddle). The solder may be dispensed from one or more syringes.

Figure 9c shows a further step in which a plurality of dies are coupled to a respective plurality of die paddles. Taking the die paddle 34 as an example, a corresponding die 80 is coupled to the die paddle 34. Coupling the die 80 may be described as the die 80 being placed onto the solder layer 78. As described above, the solder layer 78 is in turn, disposed on the die paddle 34. In the die coupling step of Figure 9c, each of the plurality of die paddles, irrespective of the number of arrays or the number of die paddles, is provided with a die. As will be appreciated from Figure 9c, at the point where dies are coupled to the die paddles, the semiconductor assemblies defined by opposing pairs of die paddles are no longer symmetrical about the plane 76. Put another way, whereas the opposing pairs of die paddles (e.g. Figure 9a) are symmetrical about a plane defined between the pair, this symmetry is not shared by the dies applied to the die paddles. Instead, the semiconductor assemblies defined by each die paddle of an opposing pair have a rotational symmetry. This is schematically indicated by arrows 79, 81, which, for one opposed pair of die paddles, point towards the gate pads for each semiconductor assembly.

Turning to Figure 9d, a further still step of the process is shown in which another layer of solder is printed, this time onto the die. Taking die paddle 34 as an example, a solder layer 82 is applied to the die 80. The solder layer 82 may otherwise be described as being printed onto, or applied to, the die 80. Like the step shown in Figure 9b, solder is applied to each die. Like in Figure 9b, the solder layer 82 is preferably applied to all of the dies in this single process step. The solder layer is preferably applied to all of the dies simultaneously. The solder layer may be applied to the dies in a consecutive manner (e.g. die by die). The solder may be dispensed from one or more syringes.

Turning to Figure 9e, a still further step of the process is shown in which a plurality of connectors are coupled to the respective plurality of dies. Again taking die paddle 34 as an example, connector 52, in the form of a clip, is coupled to the die 80. Specifically, the connector 52 is placed onto the solder layer 82 which, in turn, is applied to the die 80. The location of the connectors, on the respective semiconductor assemblies, is more clearly shown in Figures 11, 12 and 13, and will be described in detail in connection with these figures. Each of the clips comprises a plurality of leads, and a dambar which extends across the leads. Again, this will be described in detail in connection with later figures. Figure 9e also schematically indicates the relevance of the opposing orientation of the die paddles, which was shown and described in connection with Figure 9a. As will be appreciated by comparing Figures 9d and 9e, at the point of coupling the plurality of connectors to a respective plurality of dies, the connectors are oriented so that the leads for clips of an opposing pair of die paddles extend in different directions. For example, the leads of connector 52 extend towards the left for the die paddle 34, and the leads for the connector for the die paddle 72 (the other die paddle in that opposing pair) extend in the opposing, right direction. For completeness, Figure 9e shows a single connector 52 being coupled to each semiconductor assembly, as defined by each die paddle. The connector 52 will go on to be separated into the (separate) source and gate connectors 53, 55 shown in Figure 2.

Figure 9e also represents a reflow step in which the solder layers 78, 82, applied in steps shown in Figures 9b and 9d, undergo a reflow soldering process. Specifically, the arrays of semiconductor assemblies illustrated in Figure 9e are subjected to a controlled elevated temperature, such as being passed through a reflow oven or passed under an infrared lamp, to create permanent soldered joints to cure the semiconductor assemblies.

Turning to Figure 9f, a moulding step of the process is shown. For completeness, the mould geometries will be shown and described in connection with Figures 14 to 16. In Figure 9f a fused casing is moulded over all of the plurality of semiconductor assemblies for each of the two arrays 64, 66. That is to say, a first fused casing 84 is moulded over a first plurality of semiconductors corresponding to the first array 64, and a second fused casing 86 is moulded over the plurality of semiconductors assemblies corresponding to the second array 66. As shown in Figure 9f, fused casing is intended to refer to a conjoined casing of sorts in which multiple individual casings are moulded simultaneously. For example, taking the fused casing 84 as an example, the fused casing 84 will go on to be separated into ten individual casings, one for each of the ten semiconductor assemblies which constitute the first array 64. For completeness, the fused casings 84, 86 are shown in a partially transparent view in Figure 9f. Figure 9h shows an 'opaque' view.

The moulding process occurs by way of injection moulding. In the illustrated embodiment a common source 87 of molten polymer material is provided in fluid communication with multiple mould cavities (e.g. corresponding to multiple arrays). However, it will be appreciated that in other embodiments this may not be the case. Each of the moulds corresponding to fused casings 84, 86 is supplied with material via a respective runner 90, 94 in fluid communication with the common source 87.

Furthermore, the material is supplied via a respective gate 92, 96 for each mould cavity. Again, for completeness, the mould/mould cavity is not shown in Figure 9f but will be described in connection with subsequent figures.

As has been previously described, the fused casings 84, 86 at least partially surround the respective arrays 64, 66 of semiconductor assemblies. Casings for a plurality of semiconductor assemblies are therefore moulded simultaneously. There are a number of advantages associated with this simultaneous moulding including, but not limited to, being able to increase the density of die paddles on a given lead frame (due to being able to reduce the clearance around each die paddle, owing to the 'common' fused casing moulding).

In the moulding step shown in Figure 9f, and as will be described in detail in connection with Figures 14 to 17, one or more grooves, extending at least partway around an individual one of the semiconductor assemblies, may also be defined. The grooves advantageously reduce the amount of material between adjacent semiconductor assemblies, and thus reduce the amount of material that needs to be removed, during a subsequent cutting process, to singulate the conductor assemblies. However, the grooves are an optional feature. For completeness, after the moulding occurs (i.e. such that fused casings 84, 86 are moulded), tie bars extending between adjacent die paddles, and the lead frame, are obscured by the casing material.

Turning to Figure 9g, Figure 9g also shows first and second fused casings 84, 86 (in a partially transparent view) but with associated moulding features (e.g. common source 87, runners 90, 94 and gates 92, 96) removed. That is to say, the moulding process is completed by the step shown in Figure 9g.

In Figure 9g, a (multi-stage) punching process has occurred in which dambars, one for each connector (e.g. and so one for each semiconductor assembly), are removed, and leads are formed (and into displaced leads). Put another way, with reference to Figure 4, the punch line 60 is formed by way of a punching operation being carried out. Returning to Figure 9g, in the illustrated embodiment this step does not singulate the semiconductor assemblies because the die paddles in the respective arrays are still interconnected by way of tie bars and the fused casings 84, 86. However, at this point the semiconductor assemblies can be considered to be detached from the lead frame 62 on one side. Specifically, each of the semiconductor assemblies is detached from the lead frame 62 at least at the lead side. To aid explanation, the dambar of the semiconductor assembly 2, corresponding to the die paddle 34, is labelled 88 in Figure 9f. The dambar 88 provides a number of functionalities during the manufacturing process including, but not limited to, providing structural support for the leads, providing alignment of the leads with respect to the lead frame 62, and easing the moulding process by preventing molten material from escaping from the mould through the leads (or, specifically, between adjacent leads).

The punching step of Figure 9g also forms the displaced leads (i.e. leads having a change of direction) in a manner which will be appreciated by comparing Figures 12 and 13 (which show the leads in more detail). Once the leads are formed, the leads are also plated (typically with Tin(Sn)). The plating improves the corrosion resistance of the leads and improves the adherence of solder to the leads.

Turning to Figure 9h, Figure 9h shows two different orientations of one of the arrays 64, 66 before the cutting process occurs (to singulate the individual semiconductor assemblies). Figure 9h shows only one array for reasons of magnification, and is not intended to indicate that the two arrays 64, 66 of Figure 9g have been separated at this point (i.e. the same number of arrays would be retained on the lead frame 62). The left hand side orientation is taken from the perspective of the first major face 8 of the semiconductor assemblies (labelled on the semiconductor assembly 2 only). The left hand side orientation may be referred to as a plan view. The right hand side orientation shows is taken from the perspective of the second major face 10 of the semiconductor assemblies (again, labelled on the semiconductor assembly 2 only. The right hand side orientation may be referred to as a bottom view. The left hand side may be referred to as a `live bug' orientation, and the right hand side a 'dead bug' orientation. Either orientation can be used in operation. Also shown underneath the left and right hand views are the side views for each orientation.

With the punching step having been carried out in Figure 9g, the last step of the process is to cut the fused casing 84 in at least three positions surrounding each of the individual semiconductor assemblies, to define an individual casing and singulate the semiconductor assembly from the array. For example, and again with reference to semiconductor assembly 2, corresponding to die paddle 34, the fused casing 84 is cut at three positions 54, 56, 58, partially surrounding the individual semiconductor assembly 2, to singulate the semiconductor assembly 2 from the array. Also of note, it will be appreciated that the semiconductor assembly 2 is also connected to the surrounding lead frame by tie bars which extend between the die paddles which form part of the lead frame. As such, the cutting positions 54, 56, 58 will also cut the tie bars extending between the die paddles (and, where applicable, between the die paddle and the lead frame 62). The cutting operation will therefore separate the semiconductor assembly 2 from the surrounding array. As indicated in Figure 9h, specifically on the left hand side, the cutting operation may be limited to only the length corresponding to only that individual semiconductor assembly. Alternatively, the cutting operation may simultaneously cut through multiple semiconductor assemblies (e.g. line 56, to separate each of the five pairs of opposing pairs of semiconductor assemblies shown in Figure 9h). Cutting operation is intended to refer to the cutting process, and may comprise a plurality of constituent cuts. For example, the cuts at three positions 54, 56, 58 may be referred to as one cutting operation. In Figure 9h each cutting position corresponds to a length of a non-lead side of the semiconductor assembly casing. Described another way, each cutting position corresponds to a portion of an outer perimeter of an individual semiconductor assembly.

It is desirable to reduce the number of `cuts' (e.g. the number of cut lines, or positions at which cutting occurs) where possible. For a single 2 x 5 array, as shown in Figure 9h (left hand side), one (vertical, in this embodiment) cut 56 is required to separate the pairs of semiconductor assemblies. Six (i.e. n+1, for a 2 x n array) (horizontal, in this embodiment) cuts 54, 58, 57, 59, 61, 63 are required to separate the remaining semiconductor assemblies. The pair-splitting cut (e.g. 56) may be the cut which singulates the semiconductor assembly (or assemblies). One of the other cuts may be the cut which singulates the semiconductor assembly (or assemblies). For a 2 x n array, a minimum number of n+2 cuts are therefore needed.

Where the cutting comprises sawing, specifically a rotating saw blade, the lead frame 62, comprising the arrays 64, 66, may be fed to the rotating saw blade. Put another way, the lead frame 62, and so arrays 64, 66, may be moved relative to the rotating saw blade. In contrast, for some other cutting processes (e.g. reciprocating saw blade, laser cutting, water jet etc.), the position of the lead frame 62, and so arrays 64, 66, may be fixed whilst the cutting implement is moved relative thereto.

For the avoidance of doubt, the cutting operation maybe by way of a variety of different cutting processes including, but not limited to, a reciprocating or rotating blade (i.e. sawing), a laser, a waterjet or other similar process.

The right hand side of Figure 9h, showing the different orientation, would be cut in a similar manner to that shown in the left hand side of Figure 9h. However, the directionality of the cut would be different for the left/right orientations shown. For example, and where the cut is carried out by a (rotary) saw blade, in the left hand orientation the cut would be from the second major face 10 (e.g. underside) to the first major face 8 (e.g. upper face). In contrast, in the right hand orientation the cut would be from the first major face 8 (e.g. upper face) to the second major face 10 (e.g. underside). The resistance experienced by the saw, due to cutting through material of the casing and/or tie bars, will vary depending upon the material. This is one factor which may influence the directionality of the cut, and so which of the left and right hand orientations of Figure 9h is preferred. The cutting operation may also create burrs, and it may be desirable to modify the orientation to reduce the formation of burrs, or at least the visibility thereof.

Turning finally to step 9i, a singulated, individual semiconductor assembly 2 (which may be referred to as a semiconductor component or device) is shown in accordance with the earlier Figures. The upper view of Figure 9i shows an opaque view, whereas the lower view shows a partially transparent view, each corresponding to Figures 1 and 2 respectively.

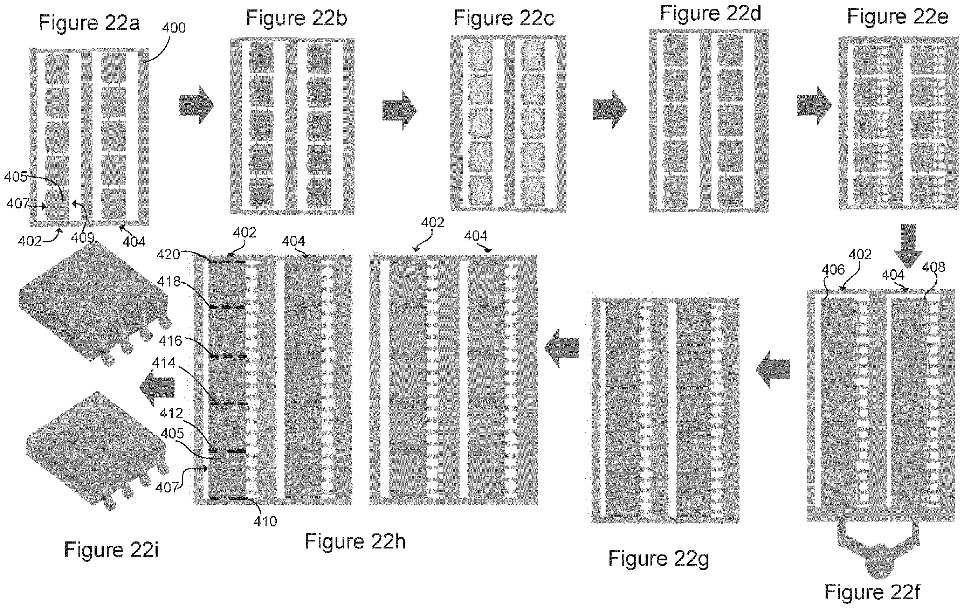

The method described above advantageously removes the need for a second punch operation to singulate a second conductor assembly, in comparison to known arrangements. As a result, the die paddles can be located closer to one another on a lead frame, owing to the 2 x n arrangement and opposing pair orientation, which means that the density of devices can also be increased. This is at least in part owing to the fact that less space is needed between adjacent die paddles in order to fit the previously separate moulds, which previously moulded separate casings. Instead, a fused casing is moulded over a plurality of semiconductor assemblies, simultaneously, which further improves the efficiency of the manufacturing process. As will be explained in connection with Figures 22a to 22i, a corresponding method, using a 1 x n array, can also be used.

Turning to Figure 10, Figure 10 shows the lead frame 62 of Figure 9a in isolation.

As previously described, the lead frame 62 comprises two 2 x 5 arrays 64, 66 of die paddles. Also as previously described, the die paddles are arranged in an array in pairs having opposing orientations. Two such pairs are schematically indicated being bound by boxes 90, 92 in Figure 10. As shown in Figure 10, the lead frame 62 also defines a lead cavity disposed at a lead end of each die paddle (e.g. lead cavity 94 at least side 20 of die paddle 34, and lead cavity 96 at lead side 74 of die paddle 72).

Taking die paddle 34 as an example, the die paddle 34 is connected to the lead frame 62 by tie bars 40, 42 (see also Figure 2). The die paddle 34 is coupled to the (opposing pair) die paddle 72 by tie bars 36, 38. The die paddle 34 is also connected to adjacent die paddle 98, of the pair labelled 92, by tie bars 22, 24.

As has previously been described, the tie bars (e.g. 22, 24 etc.) are cut, as part of the cutting process, to singulate the semiconductor assemblies, and so the individual die paddles, from one another. However, up until this point, the individual semiconductor assemblies are at least partly coupled to the lead frame 62.

Turning to Figure 11, a magnified view of Figure 9f is provided (e.g. the moulding step). Also shown are side and end views which are generally labelled 100, 102 respectively.

Figure 11 is included to more clearly show the geometry of the connectors (e.g. connector 52 for die paddle 34) during moulding and before a punching step. With reference to the die paddle 34, forming part of the first array 64, as shown in Figure 11 connector 52 has been attached and fused casing 84 moulded over at least part of the connector 52. The dambar 88 is also still present because the punching step (which removes the dambar) has not yet occurred. Once the punching step occurs, the dambar 88 is removed (e.g. the dambar 88 is punched), along with a zone of material generally indicated 104 for the adjacent die paddle. This step removes the dambar 88 and forms, in the illustrated embodiment, the four leads 6, one of which is labelled 6d. This step also separates the (single) connector 52 into the source connector 53 and gate connector 55). In this punching step the leads, which are displaced leads, are also formed insofar as they are deformed to incorporate a change of direction. For completeness, the punching step may comprise multiple punch stations (e.g. constituent punch substeps). For example, in a first substep, dambars are punched. In a second substep, ends of leads are punched. In a third, and final, substep, the (displaced) leads are formed (e.g. bent). The punching step, and optionally the three substeps set out above, may be carried out for (a row of) 5 semiconductor assemblies at a time. That is to say, for a 2 x n array, this step may be carried out for a row of n semiconductor assemblies.

Turning to Figure 12, a magnified view of the step shown in Figure 9f, after moulding the fused casing has occurred, is provided. Figure 12 therefore corresponds to a step just after that in Figure 11. Importantly, Figure 12 is also taken at a stage before a punching operation occurs on any of the semiconductor assemblies shown.

For ease of reference, Figure 12 is described in connection with a lower right hand semiconductor assembly which is labelled 104. As mentioned, the fused casing 86 has been moulded over the semiconductor assembly 104, forming part of the second array 66, and is at least partially surrounded by the second fused casing 86. The semiconductor assembly 104 comprises a connector 106, in the form of a clip, which is applied in a preceding step of the process. Figure 12 indicates that, as has previously been described, at least part of the connector 106 projects from the lead side 108 of the semiconductor assembly 104. In the step shown in Figure 12, before the lead side 108 of the semiconductor assembly 104 (specifically the connector 106 thereof) is punched, to define individual leads and cut the dambar 110, dambar 110 is still shown in situ. The connector 106 has also not yet been separated into a separate source connector and gate connector. Furthermore, the connector 106, at least an exposed portion thereof, extends at substantially 90 degrees (e.g. substantially perpendicular) relative to a major face at the lead side 108. Described another way, no displaced leads have yet been formed. See, for example, Figure 13 in contrast (showing displaced leads having been formed).

Turning now to Figure 13, Figure 13 shows the two arrays of semiconductor assemblies, shown in Figure 12, after a punching step has occurred.

Turning again to describe the semiconductor assembly 104 in detail, the punching step removes the dambar 110 (shown in Figure 12) and thus defines individual leads 108a-d of the connector 106. This step also separates the connector 106 into separate source and gate connectors 107, 109. The leads 108a-d are also formed into displaced leads insofar as they now change direction after extending substantially perpendicularly from the fused casing 108. Again, this is in contrast to the corresponding connector 106/lead geometry shown in Figure 12.

After the punching step has occurred, as shown in Figure 13, each of the arrays 64, 66 is ready for the cutting process to be carried out on the fused casings 84, 86, in at least three positions, partially surrounding individual semiconductor assemblies, to singulate the semiconductor assemblies from the respective arrays.

Turning to Figure 14, an end view of the two arrays 64, 66, during a moulding step, is provided. Figure 14 shows first and second mould sections 112, 113, specifically upper and lower sections of the mould respectively, surrounding semiconductor assemblies corresponding to the die paddles 34, 72 of the first array 64. The first and second mould sections 112, 113 cooperate to define a mould cavity.

As shown in Figure 14, the first mould section 112 comprises a tapered edge 114 proximate the die paddle 34, and a tapered edge 116 proximate the die paddle 72. The first mould section 112 also comprises a projection 118, disposed between the opposing pairs of die paddles (i.e. between die paddles 34, 72), which, in turn, comprises tapered edges (i.e. sides) 120, 122 and a flat bottom edge 124. The first mould section 112 thus creates the fused casing having the geometry shown in Figures 16 and 17.

With continued reference to Figure 14, although not shown for the second array 66, like mould sections are applied over that array also.

Turning briefly to Figure 15, Figure 15 shows a side view which corresponds to that shown in Figure 14. Figure 15 thus shows that the mould cavity surrounds the semiconductor assemblies forming part of that array.

Turning to Figure 16, Figure 16 is a magnified view of part of Figure 14, corresponding to an area which is just greater than that of the semiconductor assembly corresponding to the die paddle 34.

As shown in Figure 16, the geometry of the fused casing 84 is created by the moulding process, including the first mould section 112. With reference to Figure 2, the chamfered edge 26 (at the lead side 20) is created by the tapered edge 114 of the mould section 112. Similarly, the chamfered edge 26, at the opposing side (the second side 16) of the semiconductor assembly, is created by the tapered edge 120 of the projection 118. A portion of the lip 30, which extends partway around the semiconductor assembly 2, is also shown being defined by the bottom edge 124 of the projection 118. Said bottom edge 118 also creates a groove 126 between adjacent semiconductor assemblies, which reduces the amount of material which is cut to separate adjacent semiconductor assemblies. Said amount of material to be cut, at least of the fused casing 84, is indicated 128. The groove 126 may extend continuously around, for example, three sides of a perimeter of a semiconductor assembly. Alternatively, the groove may be may be intermittent (i.e. not extend continuously). Where the groove extends continuously, the groove preferably extends along each of the cutting lines 54, 56, 58 as labelled in Figure 4. The groove is preferably located at a top side of the semiconductor assembly (e.g. extends from a first major face).

Turning finally to Figure 17, Figure 17 shows part of the array of semiconductor assemblies shown in Figure 16 with the first mould section 112 removed. Figure 17 thus shows more clearly the groove 126, the groove having a depth labelled 130. The depth 130 of the groove 126 is preferably at least around one third of an overall thickness of the fused casing, which is labelled 132. As described in connection with Figure 9h, the material 128 extending between adjacent semiconductor assemblies is removed by a cutting operation. Removal of this material singulates the adjacent semiconductor assemblies, at least in the illustrated embodiment, and also defines the lip 30 (which can effectively be considered to be created by virtue of a manufacturing tolerance associated with the cutting operation). A width 134 of the groove at the lower side (e.g. created by the bottom edge 118 of Figure 16) is preferably wider than that of a cutting tool used in the cutting operation. Incorporation of the groove(s) has also been found to advantageously provide a stress relieving functionality in the fused casing. That is to say, the fused casing is less likely to become damaged, during the moulding process, where grooves are incorporated.

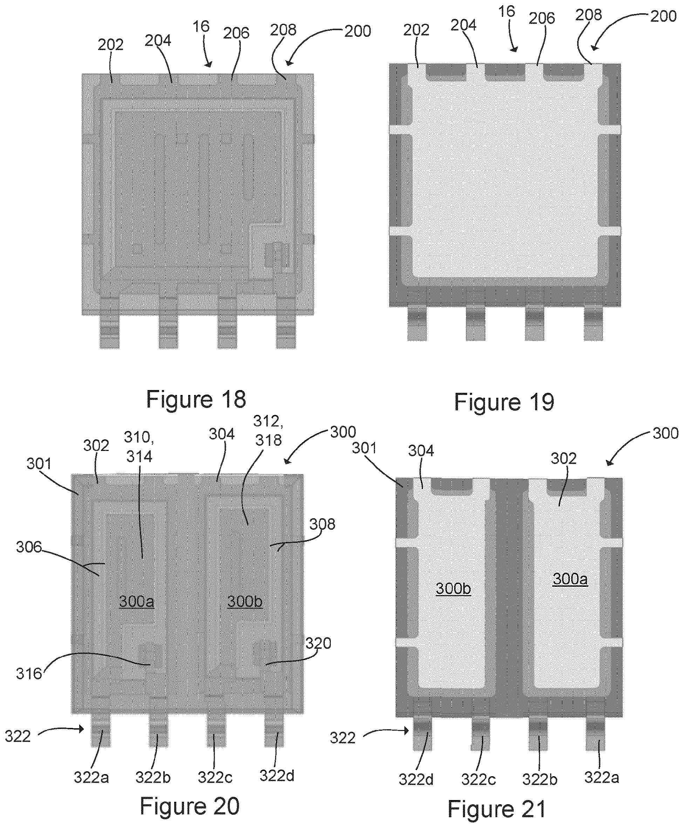

Figures 18 and 19 show a semiconductor assembly 200 according to another embodiment (in a partially transparent plan, and partially transparent underside, view respectively). At a lead side 16 of the semiconductor assembly 200, four tie bars 202, 204, 206, 208 are disposed. Figures 18 and 19 thus indicate that the invention is not limited to a particular arrangement, or number, of tie bars. Save for this difference, the semiconductor assembly 200 corresponds to the earlier embodiment.

Figures 20 and 21 show a semiconductor assembly 300 according to another embodiment (in a partially transparent plan, and partially transparent underside, view respectively). The semiconductor assembly 300 is show in singulated form, with a single casing 301, but comprises two die paddles 302, 304, two dies, 306, 308 and two connectors 310, 312 (first and second connectors). The first connector 310 comprises a source connector 314 and a gate connector 316. Similarly, the second connector 312 comprises a source connector 318 and a gate connector 320. The semiconductor assembly 300 comprises four leads 322a-d (collectively referred to as leads 322). Leads 322a and 322c are first and second source leads (i.e. in communication with the source connectors 314, 318 of the first and second connectors 310, 312 respectively). Leads 322b and 322d are first and second gate leads (i.e. in communication with the gate connectors 316, 320 of the first and second connectors 310, 312 respectively). The semiconductor assembly 300 thus comprises two electrically isolated subassemblies 300a, 300b, which are housed in a common casing 301. Such embodiment is readily manufactured using the process shown and described in connection with Figures 9a-i. Save for the differences mentioned above, the semiconductor assembly 300 corresponds to the earlier embodiments 2, 200. Of note, first and second connectors 310, 312 may be coupled to the respective dies as a single 'master' connector which is subsequently separated by punching.

Turning to Figures 22a-i, a method of manufacturing a batch of semiconductor assemblies according to another embodiment is schematically illustrated. Figures 22a-i generally correspond to the method steps shown in Figures 9a-i respectively, but for a lead frame 400 having a 1 × 5 array of die paddles (e.g. in contrast to the lead frame 62, in Figures 9a-i, comprising first and second 2 x 5 arrays 64, 66 of die paddles). Put another way, Figures 22a-i show a method for manufacturing semiconductor assemblies in a single row. Only the steps differing from the corresponding step of Figures 9a-i will be described in detail, for brevity.

Beginning with Figure 22a, as mentioned above the lead frame 400 comprises two 1 × 5 arrays 402, 404 of die paddles. The die paddles of each array 402, 404 may be described as being arranged in a single column, or row. Unlike the lead frame 62, for the lead frame 400 each die paddle is coupled to two other die paddles or one other die paddle and the lead frame 400 (for 'end' die paddles). In contrast, for the lead frame 400 each die paddle is coupled to three other die paddles or two other die paddles and the lead frame 62 (again, for 'end' die paddles). Die paddles of the lead frame 400 are also not arranged in pairs, less opposing pairs, given that they are arranged in a single row. Taking a first die paddle 405 on the lead frame 400 as an example, a second side 407 of the die paddle 405 (i.e. opposite a lead side 409), is not coupled to the lead frame 400. Put another way, a non-lead side of the die paddle 405 is 'free', as is the lead side 409 as shown in Figure 22a.

The steps shown in each of Figures 22b to 22e correspond closely to that of Figures 9b to 9e respectively, and will therefore not be described in detail. Of note, like Figure 9e, in Figure 22e leads of connectors extend from a single (lead) side of each of the semiconductor assemblies only.

Turning to Figure 22f, a moulding step, first and second fused casings 406, 408 are moulded. First and second fused casings 406, 408 are moulded over semiconductor assemblies corresponding to the first and second arrays 402, 404 respectively. Each fused casing 406, 408 thus at least partially surrounds five semiconductor assemblies, as opposed to the ten for each of first and second fused casings 84, 86 shown in Figure 9f.

Turning to Figure 22g, a punching step occurs in a similar manner to that shown in Figure 9g (albeit on fewer connectors).

Turning to Figure 22h, like Figure 9h a left hand side view shows the arrays in plan view, and a right hand side view shows the arrays from an underside. Like Figure 9h, Figure 22h schematically indicates cut lines by which the semiconductor assemblies of the first array 402 are singulated. Given that the semiconductor assemblies in each array 402, 404 are not arranged in (opposed) pairs, and are instead arranged in 1 × 5 rows, the number of cuts required is reduced by one in contrast to the singulation step of Figure 9h. This is owing to the non-lead side (e.g. 407 for die paddle 405) being a 'free' side not coupled to the lead frame 400 (again, in contrast to that shown in Figure 9h). Cutting at two positions, with the punching having occurred in the step shown in Figure 22g, will singulate the semiconductor assemblies from the array 402. Those two positions are the first and third sides (or edges), adjacent the lead side. In this embodiment, the two cut positions are parallel to one another, with a punch line disposed, and extending, therebetween.

Figure 22i shows a singulated semiconductor assembly from the method shown in steps Figure 22a-h.

Throughout this document, it will be appreciated that lead sides of a die paddle and semiconductor assembly refer to the same general region. However, a lead side of the semiconductor assembly may refer to the leads of the connector, whereas a lead side of the die paddle may refer to only an edge of the die paddle proximate the leads (once assembled). A lead side of the casing may refer to a side of the casing from which the leads extend.

Throughout this document, a semiconductor assembly may otherwise be referred to as a package.

## Claims

1. A method of manufacturing a batch of semiconductor assemblies, comprising:
coupling a plurality of dies to a plurality of die paddles, the plurality of die paddles being provided on a lead frame in a 2 x n array in pairs having an opposing orientation, wherein each die paddle defines a respective semiconductor assembly;
coupling a plurality of connectors to the plurality of dies;
moulding a fused casing over the plurality of semiconductor assemblies using a mould which surrounds the 2 x n array, the fused casing at least partly surrounding the 2 x n array; and
cutting the fused casing at at least three positions, partially surrounding an individual one of the plurality of semiconductor assemblies, and punching a lead side of the semiconductor assembly, to define an individual casing, from the fused casing, and singulate the semiconductor assembly from the 2 x n array.

2. The method according to claim 1, wherein moulding the fused casing comprises defining a groove which extends at least partway around one of the plurality of semiconductor assemblies.

3. The method according to claim 2, wherein the groove extends continuously around the three positions of the fused casing partially surrounding the individual one of the plurality of semiconductor assemblies.

4. The method according to claims 2 or 3, wherein the groove is at least partially tapered.

5. The method according to any one of claims 2 to 4, wherein the groove comprises a flat surface proximate a respective die paddle.

6. The method according to any one of claims 2 to 5, wherein the groove extends through at least 1/3 of a thickness of the individual casing.

7. The method according to any preceding claim, wherein punching the lead side of the semiconductor assembly to define the individual casing occurs before cutting the fused casing at at least three positions.

8. The method according to claim 7, wherein cutting the fused casing at at least three positions singulates the semiconductor assembly from the 2 x n array.

9. The method according to any preceding claim, wherein the lead frame comprises a plurality of 2 x n arrays of die paddles, pairs of the die paddles of each 2 x n array being provided in an opposing orientation; and
moulding the fused casing comprises moulding a plurality of fused casings, one for each of the plurality of 2 x n arrays of die paddles.

10. The method according to claim 9, wherein the plurality of fused casings are moulded simultaneously by supplying molten material, from a common source, through a respective runner for each fused casing.

11. The method according to any preceding claim, wherein punching the lead side of the semiconductor assembly comprises forming one or more displaced leads.

12. A semiconductor assembly manufactured using the method according to any preceding claim.

13. An array of semiconductor assemblies, comprising:
a lead frame comprising a 2 x n array of die paddles, the die paddles being arranged in pairs having an opposing orientation, wherein each die paddle defines a respective semiconductor assembly;
a plurality of dies coupled to a respective plurality of die paddles;
a plurality of connectors coupled to the respective plurality of dies;
a fused casing moulded over the plurality of semiconductor assemblies, the fused casing at least partly surrounding the 2 x n array; wherein
each of the plurality of semiconductor assemblies comprises one or more leads extending from a lead side of the semiconductor assembly.

14. A method of manufacturing a batch of semiconductor assemblies, comprising:
coupling a plurality of dies to a plurality of die paddles, the plurality of die paddles being provided on a lead frame in an array, wherein each die paddle defines a respective semiconductor assembly;
coupling a plurality of connectors to the plurality of dies;
moulding a fused casing over the plurality of semiconductor assemblies using a mould which surrounds the array, the fused casing at least partly surrounding the array; and
cutting the fused casing at at least two positions, partially surrounding an individual one of the plurality of semiconductor assemblies, and punching a single, lead side of the semiconductor assembly, to define an individual casing, from the fused casing, and singulate the semiconductor assembly from the array.

15. A semiconductor assembly, comprising:
a die paddle;
a die coupled to the die paddle;
a connector coupled to the die, the connector comprising one or more leads that extend from a single lead side of the die paddle; and
a casing which extends to three sides of the die paddle;
wherein the one or more leads are displaced leads.
